# EUROPÄISCHE PATENTSCHRIFT

(11) **EP 4 322 195 B1**
(45) Veröffentlichungstag und Bekanntmachung des Hinweises auf die Patenterteilung: **15.04.2026**
(21) Anmeldenummer: 23185496.9
(22) Anmeldetag: 14.07.2023
(51) Int. Cl.: H01H 71/08, H01H 9/26, H01H 71/02, H01R 9/26

(54) **VERBINDER FÜR EINEN LEISTUNGSSCHALTER UND EIN NACHGELAGERTES SCHÜTZ, ABZWEIG MIT SOLCH EINEM VERBINDER UND ANORDNUNG MIT SOLCH EINEM ABZWEIG**
CONNECTOR FOR A CIRCUIT BREAKER AND A DOWNSTREAM CONTACTOR, TAP COMPRISING SUCH A CONNECTOR AND ASSEMBLY COMPRISING SUCH A TAP
CONNECTEUR POUR DISJONCTEUR ET CONTACTEUR DE POST-CONNEXION, BRANCHEMENT COMPRENANT UN TEL CONNECTEUR ET ENSEMBLE COMPRENANT UN TEL DÉRIVATION

(30) Priorität: 11.08.2022 DE 102022208368
(43) Veröffentlichungstag der Anmeldung: 14.02.2024
(73) Patentinhaber: Siemens Aktiengesellschaft, 80333 München (DE)
(72) Erfinder: Bodenmeier, Martin, 92711 Parkstein (DE); Kemptner, Tobias, 92269 Fensterbach (DE); Steinbauer, Martin, 92287 Schmidmühlen (DE)
(74) Vertreter: Siemens Patent Attorneys

(56) Entgegenhaltungen:
- EP-A1- 2 140 471
- EP-A2- 0 908 914
- EP-B1- 2 140 471
- WO-A1-2008/034396
- CN-B- 103 107 486
- DE-A1- 102005 040 348

## Beschreibung

Die Erfindung betrifft einen Verbinder für einen Leistungsschalter und ein nachgelagertes Schütz, einen Abzweig mit solch einem Verbinder und eine Anordnung aus einem Verteilnetz, einem Verbraucher und solch einem Abzweig.

Um Verbraucher, wie beispielsweise Motoren, zu schalten, werden bis dato sogenannte Abzweige verwendet, die aus einem Leistungsschalter und einem nachgelagerten Schütz bestehen. Das nachgelagerte Schütz steuert den Verbraucher, wie beispielsweise den Motor, an. Der Leistungsschalter übernimmt dabei die Schutzfunktionen wie Kurzschlussschutz, Überlastschutz und Phasenausfallschutz. Das nachgelagerte Schütz ermöglicht das leistungsbeaufschlagte, regelmäßige Schalten der Verbraucher.

Typische Abzweige sind aktuell noch nicht flächendeckend in der digitalen Welt der Zukunft integriert. Bei der digitalen Integration sind mehrere Randbedingungen zu beachten, wie beispielsweise der Footprint von Abzweigen, die Zugänglichkeit der Anschlussstellen, Temperaturbedingungen der Elektronik, verschiedene Ausbaustufen der Kommunikation, das Handling beim Aufbau, Nachrüstbarkeit bei bestehenden Anlagen und die Verwendbarkeit des bisherigen Zubehörs. Typische Abzweige mit Elektronik haben unterschiedliche Aufbauten und dadurch unterschiedliche Gehäuse. Dies führt sehr oft dazu, dass sich Produkte wegen der hohen Investitionen in das Design der Abzweige nicht rentieren.

Die WO 2008/034396 A1 betrifft einen Adapter zur Herstellung einer elektrisch leitenden Verbindung zwischen zumindest einer Hauptstrombahn eines Schaltgerätes und einer Auswerteeinheit zur Ermittlung des Zustandes einer dem Schaltgerät vorgeschalteten Schutzvorrichtung. Um eine Überwachung einer dem Schaltgerät vorgeschalteten Schutzvorrichtung mit minimalem Verdrahtungsaufwand zu ermöglichen, wird ein Adapter vorgeschlagen zur Herstellung einer elektrisch leitenden Verbindung zwischen zumindest einer Hauptstrombahn eines Schaltgerätes und einer Auswerteeinheit zur Ermittlung des Zustandes einer dem Schaltgerät vorgeschalteten Schutzvorrichtung, wobei der Adapter mechanisch mit dem Schaltgerät verbindbar ist und Kontaktschnittstellen zum Anschluss der Auswerteeinheit aufweist. Durch die direkte Auswertung des Schaltzustands des Schutzorgans am Schaltgerät entfällt die bisher erforderliche Verdrahtung zu einem zusätzlichen Hilfsschalter am Schutzgerät, wobei mit dem Verdrahtungsaufwand auch eine mögliche Fehlerquelle minimiert wird.

Die DE 10 2005 040348 A1 betrifft ein Verbindungssystem mit einem elektromagnetischen Schaltgerät, insbesondere Schütz, und einem Stecker. Um das Anschließen von Hilfs- und Steuerleitungen bei elektromagnetischen Schaltgeräten zu erleichtern, wird ein Verbindungssystem vorgeschlagen, mit wenigstens einem elektromagnetischen Schaltgerät, insbesondere Schütz, wobei das Schaltgerät eine Anzahl von Hilfsschalteranschlüssen und einen Spulenanschlussklemmenblock aufweist und wobei der Spulenanschlussklemmenblock derart ausgestaltet ist, dass dessen Spulenanschlüsse in einer Ebene mit wenigstens einem Hilfsschalteranschluss liegen, und mit einem Stecker zur gleichzeitigen Kontaktierung der in einer Ebene liegenden Spulen- und Hilfsschalteranschlüsse eines oder mehrerer Schaltgeräte, wobei der Stecker eine interne Verdrahtung aufweist zur elektrischen Verbindung der Spulen und/oder Hilfsschalteranschlüsse untereinander.

Die CN 103 107 486 B betrifft ein modulares Mess- und Steuergerät für Schalterzuleitungen mit einem einzigen Schaltkreis und einem Kunststoffgehäuse, das eine Befestigungsplatte zum Befestigen eines Schalters, ein Sammelmodul zum Sammeln von zu messenden Signalen am Schalter und ein Steuermodul zum Durchführen einer Datenanalyse der vom Sammelmodul gesammelten zu messenden Signale und zum Erhalten von Informationen über Verbrauch, Fehlerursache oder Funktionszustand des Schalters umfasst, wobei das Steuermodul in einem Plug-in- und Plug-out-Modus mit dem Sammelmodul verbunden ist. Die Mess- und Regeleinrichtung verfügt weiterhin über einen Zuleitungsanschluss, mit dessen Hilfe eine primäre Kupferschiene am Sammelmodul nach extern geschaltet werden kann. Das Problem, dass eine unabhängige Produktion im herkömmlichen Verteilungsmodus nicht durchgeführt werden kann, wird gelöst, das Sicherheitsniveau wird erhöht, die Sekundärleitung in einem Rückleitungskreis wird reduziert, die Bearbeitungszeit wird verkürzt, die Arbeitseffizienz wird verbessert, die Produktqualität wird verbessert und das modularisierte Mess- und Steuergerät für Schalter-Zuleitungsleitungen mit einem Stromkreis aus Kunststoff kann breit im Bereich von Wechselstrom-Gleichstrom-Stromversorgungstafeln, Steuerschränken, Verteilerschränken, Verteilerkästen und dergleichen eingesetzt werden.

Die EP 2 140 471 A1 betrifft ein Verbindungselement zum Verbinden von zumindest zwei Schaltgeräten sowie ein Schaltgerät und ein elektrisches Verteilungssystem. Um ein schnelles und kabelloses Verbinden von mehreren elektromechanischen Geräten zu ermöglichen, wird ein Verbindungselement zum Verbinden von zumindest zwei Schaltgeräten vorgeschlagen, wobei das Verbindungselement erste Mittel zum mechanischen Verbinden der Schaltgeräte miteinander und zweite Mittel zum elektrischen Verbinden von Schaltpolen der Schaltgeräte aufweist, wobei die zweiten Mittel flexibel ausgestaltete Anschlusselemente zum Anschluss an mit den Schaltpolen elektrisch verbundene Anschlussmittel der Schaltgeräte aufweisen.

Es ist daher Aufgabe der Erfindung, einen Verbinder für einen Leistungsschalter mit nachgelagertem Schütz zur Verfügung zu stellen, welcher in besonders einfacher Weise bestehende Komponenten integriert und zukunftssicher an wechselnde Bedarfe angepasst werden kann durch eine Aufbauanordnung oder Plattform.

Diese Aufgabe wird erfindungsgemäß durch den Verbinder für einen Leistungsschalter und ein nachgelagertes Schütz gemäß Patentanspruch 1 gelöst. Vorteilhafte Ausgestaltungen des erfindungsgemäßen Verbinders sind in den Unteransprüchen 2 bis 7 angegeben. Die Aufgabe wird erfindungsgemäß ebenfalls durch den Abzweig gemäß Patentanspruch 8 gelöst. Vorteilhafte Ausgestaltungen des erfindungsgemäßen Abzweigs sind in den Unteransprüchen 9 und 10 angegeben. Die Aufgabe wird erfindungsgemäß ebenfalls durch die Anordnung gemäß Patentanspruch 11 gelöst.

Der Verbinder für einen Leistungsschalter und ein nachgelagertes Schütz gemäß Patentanspruch 1 ist dadurch gekennzeichnet, dass der Verbinder einstückig ausgebildet ist, wobei der Verbinder die elektrische Verbindung zwischen dem Leistungsschalter und dem nachgelagerten Schütz ermöglicht und mindestens einen Sensor umfasst, wobei der Verbinder eine Auswerteeinheit für die Messwerte des Sensors umfasst, und wobei der Verbinder erste Kontakte zum Leistungsschalter und zweite Kontakte zum nachgelagerten Schütz in gleicher Streckrichtung umfasst.

Vorteilhaft hierbei ist, dass die Elektronik im Verbinder untergebracht ist, dort an einer Stelle platziert werden kann, an der die Temperaturen am geringsten sind, was wesentliche Vorteile für die elektronischen Bauteile zur Folge hat. Ebenso ist vorteilhaft, dass die Reihenfolge der Verbindung des erfindungsgemäßen Verbinders dem Kunden bekannt ist. Des Weiteren können alles bisherigen Zubehörbauteile des Systembaukastens weiter verwendet werden wie beispielsweise Wendeverdrahtungsbausteine, seitliche Zubehöre, Einspeisesysteme und Montageplatten. Der Verbinder hat den gleichen Footprint, somit ist ein gemischter Aufbau möglich. Alle bisherigen Abzweige in Federzuganschlusstechnik können problemlos mit dem erfindungsgemäßen Verbinder nachgerüstet werden. Es gibt viele Variationsmöglichkeiten für den Kunden bei nur geringer Änderung des Fertigungsaufwands, teure Werkzeugvarianten fallen nicht an und es kann Varianz über Bestückoptionen der Leiterplatte oder verschiedener Firmware / Software erzeugt werden. Ebenso ist keine Anpassung an den Grundgeräten nötig. Es können die in Masse hergestellten und somit günstigen Grundgeräte ohne irgendeine Anpassung verwendet werden. Sehr viele mögliche Applikationen können mit günstigen Grundgeräten geschaffen werden. Varianz besteht nicht in den Grundgeräten, sondern in der Ausprägung der Leiterplatte des erfindungsgemäßen Verbinders.

In einer Ausgestaltung des erfindungsgemäßen Verbinders ist der Sensor als Sensor zur Strommessung, beispielsweise als Stromwandler, und/oder als Sensor zur Spannungsmessung ausgebildet.

In einer weiteren Ausgestaltung des erfindungsgemäßen Verbinders ist der Sensor elektrisch zwischen den ersten Kontakten und den zweiten Kontakten im oder am Hauptstromkreis angeordnet.

In einer weiteren Ausgestaltung umfasst der Verbinder eine Ansteuerung des nachgelagerten Schützes. Ebenso kann der Verbinder eine Kommunikationsschnittstelle umfassen. Weiterhin kann der Verbinder einen Abfragestößel für die Schütz-Stellungsanzeige umfassen. Des Weiteren kann der Verbinder eine Ansteuerung eines Wendeschütz umfassen.

Der Abzweig gemäß Patentanspruch 8 umfasst einen Leistungsschalter, ein nachgelagertes Schütz und einen erfindungsgemäßen Verbinder, wobei der Verbinder die mechanische und/oder elektrische Verbindung zwischen dem Leistungsschalter und dem nachgelagerten Schütz bildet.

In einer erfindungsgemäßen Ausgestaltung des Abzweigs sind der Verbinder, der Leistungsschalter und das nachgelagerte Schütz werkzeuggebunden miteinander verbunden.

In einer weiteren Ausgestaltung des erfindungsgemäßen Abzweigs kann durch den Abzweig ein elektrischer Motor als Verbraucher versorgt werden.

Die Anordnung aus einem Verteilnetz, einem Verbraucher und einem erfindungsgemäßen Abzweig zum Schalten eines Verbrauchers gemäß Patentanspruch 11 ist dergestalt, dass der Abzweig zwischen dem Verteilnetz und dem Verbraucher angeordnet ist.

Die oben beschriebenen Eigenschaften, Merkmale und Vorteile dieser Erfindung, sowie die Art und Weise wie sie erreicht werden, werden klarer und deutlicher verständlich im Zusammenhang mit der folgenden Beschreibung der Ausführungsformen, die im Zusammenhang mit den Figuren näher erläutert werden.

Dabei zeigen:
- Figur 1A und 1B: Erfindungsgemäßer Verbinder mit Leistungsschalter und nachgelagertem Schütz;
- Figur 2: erfindungsgemäßer Verbinder;
- Figur 3: Leistungsschalter und nachgelagertes Schütz sowie erfindungsgemäßer Verbinder vor der Montage; und
- Figur 4: Anordnung aus einem Verteilnetz, einem Verbraucher und einem erfindungsgemäßen Abzweig.

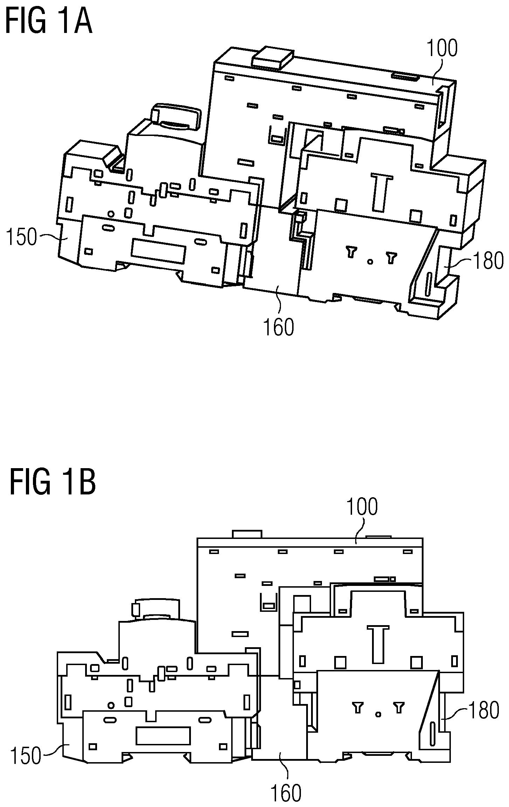

In Figuren 1A und 1B ist ein elektrischer Verbinder 100 für einen Leistungsschalter 150 und ein nachgelagertes Schütz 180 dargestellt. Der Verbinder 100 ist einstückig ausgebildet, wobei der Verbinder 100 die elektrische Verbindung zwischen dem Leistungsschalter 150 und dem nachgelagerten Schütz 180 ermöglicht und mindestens einen Sensor 200 umfasst. Des Weiteren umfasst der Verbinder 100 eine Auswerteeinheit 210 für die Messwerte des Sensors 200, und erste Kontakte 101 zum Leistungsschalter 150 und zweite Kontakte 102 zum nachgelagerten Schütz 180 in gleicher Steckrichtung.

Zusätzlich zum Verbinder 100 und dem Leistungsschalter 150 und dem nachgelagerten Schütz 180 kann ein mechanischer Verbinder 160 vorgesehen sein, der den Leistungsschalter 150 vom nachgelagerten Schütz 180 beabstandet und zusätzlich als Auflagefläche für den Verbinder 100 dienen kann.

In den Darstellungen der Figuren 1A und 1B ist der erfindungsgemäße Verbinder 100 am Leistungsschalter 150 und dem nachgelagerten Schütz 180 montiert.

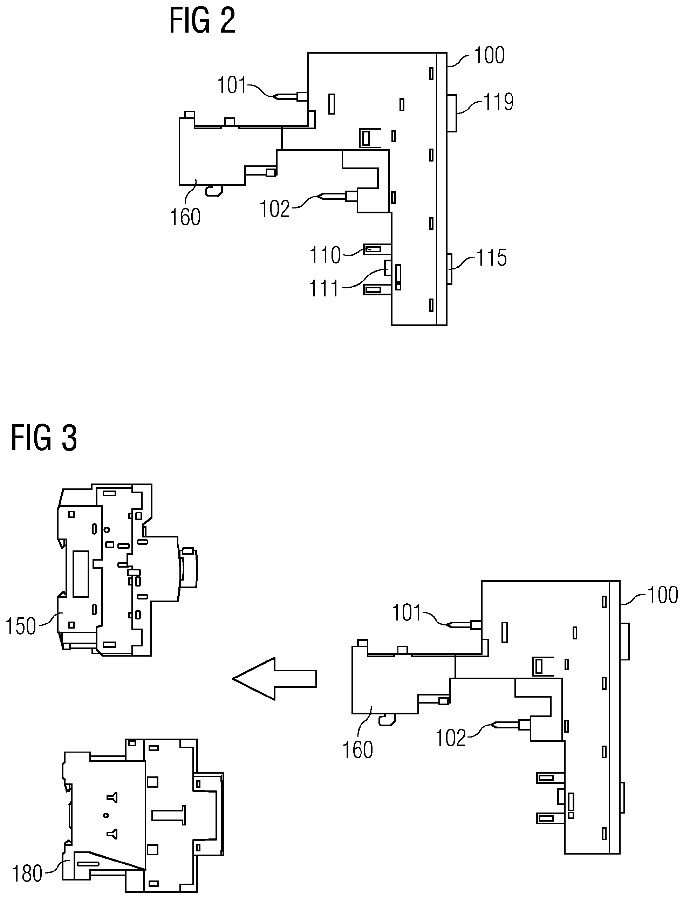

Figur 2 zeigt den erfindungsgemäßen Verbinder 100 und den mechanischen Verbinder 160. Der Verbinder 100 umfasst erste Kontakte 101, die dem Verbinder 100 mit dem Leistungsschalter 150 elektrisch verbinden und zweite Kontakte 102, die den Verbinder 100 mit dem nachgelagerten Schütz 180 elektrisch verbinden. Erste Kontakte 101 und zweite Kontakte 102 sind in gleicher Steckrichtung, was bedeutet, dass der erfindungsgemäße Verbinder 100 durch eine einzige Montagebewegung gleichzeitig mit dem Leistungsschalter 150 und dem nachgelagerten Schütz 180 verbunden werden kann.

Der Sensor 200 des erfindungsgemäßen Verbinders 100 kann als Sensor zur Strommessung, beispielsweise als Stromwandler, und/oder als Sensor zur Spannungsmessung ausgebildet sein. Der Sensor 200 kann elektrisch zwischen den ersten Kontakten 101 und den zweiten Kontakten 102 im oder am Hauptstromkreis angeordnet sein.

Der erfindungsgemäße Verbinder 100 kann des Weiteren eine Ansteuerung 110 des nachgelagerten Schützes 180 umfassen, sowie eine Kommunikationsschnittstelle 119. Die Kommunikationsschnittstelle 119 kann beispielsweise als Stecker oder Buchse für eine drahtgebundene Verbindung ausgebildet sein, ebenso kann die Kommunikationsschnittstelle 119 eine drahtlose Funkverbindung mittels typischer Protokolle wie Zigbee, Wifi oder andere aufbauen.

Weitere Elemente am erfindungsgemäßen Verbinder 100 können ein Abfragestößel 111 für die Schütz-Stellungsanzeige sein und eine Ansteuerung 115 eines Wendeschütz.

Figur 3 zeigt die Montage des erfindungsgemäßen Verbinders 100 auf dem Leistungsschalter 150 und dem nachgelagerten Schütz 180. Dadurch, dass die ersten Kontakte 101 und die zweiten Kontakte 102 des Verbinders 100 in gleicher Steckrichtung ausgebildet sind, kann durch eine einzige Steckbewegung der erfindungsgemäße Verbinder 100 am Leistungsschalter 150 und dem nachgelagerten Schütz 180 montiert werden. Entsprechend der Darstellung der Figur 3 bedeutet dies, dass der erfindungsgemäße Verbinder 100 in einer Bewegung nach links auf den Leistungsschalter 150 und das nachgelagerte Schütz 180 aufgeschoben beziehungsweise aufgesteckt werden kann.

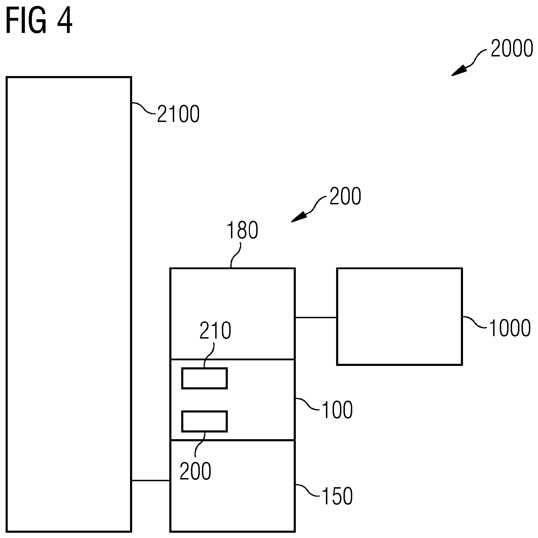

In Figur 4 ist eine Anordnung 2000 aus einem Verteilnetz 2100, einem Verbraucher 1000 und einem Abzweig 200 zum Schalten eines Verbrauchers 1000 dargestellt. Der Abzweig 200 umfasst wiederum einen Leistungsschalter 150, ein nachgelagertes Schütz 180 und einen erfindungsgemäßen Verbinder 100, wobei der Verbinder 100 die mechanische und/oder elektrische Verbindung zwischen dem Leistungsschalter 150 und dem nachgelagerten Schütz 180 bildet.

Am nachgelagerten Schütz 180 ist der Verbraucher 1000 elektrisch angeordnet, beispielsweise ein Motor.

Der erfindungsgemäße Verbinder umfasst einen Sensor 200 und eine Auswerteeinheit 210.

Der Abzweig 200 kann dergestalt ausgebildet sein, dass der Verbinder 100, der Leistungsschalter 150 und das nachgelagerte Schütz 180 werkzeuggebunden miteinander verbunden sind.

In der Anordnung 2000 ist der Abzweig 200 elektrisch zwischen dem Verteilnetz 2100 und dem Verbraucher 1000 angeordnet, in dem das Verteilnetzwerk 2100 mit dem Leistungsschalter 150 elektrisch verbunden ist und der Verbraucher 1000 elektrisch verbunden ist mit dem nachgelagerten Schütz 180.

Die Elektronik des erfindungsgemäßen Verbinders 100, insbesondere die Auswerteeinheit 210, kann so innerhalb des Verbinders 100 angeordnet sein, dass ein relativ niedriges und beherrschbares Temperaturprofil auf sie wirkt. Nur so gelingt es sinnvoll, Elektronik im Verbinder 100 beziehungsweise im Abzweig 200 einzusetzen.

Die Steckrichtung der Hauptstromklemmen wie der ersten Kontakte 101 und der zweiten Kontakte 102 ist gleich gerichtet und zwar 90° zur Geräteanordnung. Auch alle anderen elektrischen Verbindungen sind in dieser gleichen Steckrichtung angeordnet wie beispielsweise die Ansteuerung 110 des nachgelagerten Schützes 180. Nur dadurch ist es möglich, ein System zu schaffen, welches leicht in schon bestehende Systeme zu integrieren ist. Zusätzlich ist die Schütz-Schaltrichtung gleich zur Steckrichtung, wodurch eine einfache, aber wichtige Abfrage der Schütz-Stellung über den Abfragestößel 111 möglich ist.

Durch die Steckrichtung von vorn auf den Leistungsschalter 150 und das nachgelagerte Schütz 180 ist ein Toleranzausgleich im Abzweig 200 möglich. Durch das Aufbiegen der ersten Kontakte 101 und der zweiten Kontakte 102 für die Hauptstrombahn kann dieser Toleranzausgleich einfach und betriebssicher gewährleistet werden. Vorteilhaft bei dieser Anordnung ist auch, dass der Footprint des erfindungsgemäßen Abzweigs 200 gleich bleibt und fast das komplett bestehende Zubehör wie sämtliche Anbaumodule, Einspeisesysteme usw. weiterverwendet werden können. Auch das Nachrüsten aller bisher verkauften Federzugabzweige ist möglich.

## Patentansprüche

1. Verbinder (100) für einen Leistungsschalter (150) und ein nachgelagertes Schütz (180),
**dadurch gekennzeichnet, dass**
der Verbinder (100) einstückig ausgebildet ist,
wobei der Verbinder (100) die elektrische Verbindung zwischen dem Leistungsschalter (150) und dem nachgelagerten Schütz (180) ermöglicht und mindestens einen Sensor (200) umfasst,
wobei der Verbinder (100) eine Auswerteeinheit (210) für die Messwerte des Sensors (200) umfasst, und
wobei der Verbinder (100) erste Kontakte (101) zum Leistungsschalter (150) und zweite Kontakte (102) zum nachgelagerten Schütz (180) in gleicher Steckrichtung umfasst.

2. Verbinder (100) für einen Leistungsschalter (150) und ein nachgelagertes Schütz (180) gemäß Anspruch 1, wobei der Sensor (200) als Sensor zur Strommessung, beispielsweise als Stromwandler, und/oder als Sensor zur Spannungsmessung ausgebildet ist.

3. Verbinder (100) für einen Leistungsschalter (150) und ein nachgelagertes Schütz (180) gemäß Anspruch 1 oder 2, wobei der Sensor (200) elektrisch zwischen den ersten Kontakten (101) und den zweiten Kontakten (102) im oder am Hauptstromkreis angeordnet ist.

4. Verbinder (100) für einen Leistungsschalter (150) und ein nachgelagertes Schütz (180) gemäß Anspruch 1, 2 oder 3, wobei der Verbinder (100) eine Ansteuerung (110) des nachgelagerten Schützes (180) umfasst.

5. Verbinder (100) für einen Leistungsschalter (150) und ein nachgelagertes Schütz (180) gemäß einem der vorherigen Ansprüche, wobei der Verbinder (100) eine Kommunikationsschnittstelle (119) umfasst.

6. Verbinder (100) für einen Leistungsschalter (150) und ein nachgelagertes Schütz (180) gemäß einem der vorherigen Ansprüche, wobei der Verbinder (100) einen Abfragestößel (111) für die Schütz-Stellungsanzeige umfasst.

7. Verbinder (100) für einen Leistungsschalter (150) und ein nachgelagertes Schütz (180) gemäß einem der vorherigen Ansprüche, wobei der Verbinder (100) eine Ansteuerung (115) eines Wendeschütz umfasst.

8. Abzweig (200) zum Anbinden eines Verbrauchers (1000), wobei der Abzweig (200) einen Leistungsschalter (150), ein nachgelagertes Schütz (180) und einen Verbinder (100) gemäß einem der vorherigen Ansprüche umfasst, wobei der Verbinder (100) die mechanische und/oder elektrische Verbindung zwischen dem Leistungsschalter (150) und dem nachgelagerten Schütz (180) bildet.

9. Abzweig (200) zum Anbinden eines Verbrauchers (1000) gemäß Anspruch 8, wobei der Verbinder (100), der Leistungsschalter (150) und das nachgelagerte Schütz (180) werkzeuggebunden miteinander verbunden sind.

10. Abzweig (200) zum Anbinden eines Verbrauchers (1000) gemäß Anspruch 8 oder 9, wobei durch den Abzweig (200) ein elektrischer Motor als Verbraucher (1000) versorgt werden kann.

11. Anordnung (2000) aus einem Verteilnetz (2100), einem Verbraucher (1000) und einem Abzweig (200) zum Schalten eines Verbrauchers (1000) gemäß einem der vorherigen Ansprüche 8 bis 10, wobei der Abzweig (200) zwischen dem Verteilnetz (2100) und dem Verbraucher (1000) angeordnet ist.

## Claims

1. Connector (100) for a circuit breaker (150) and a downstream contactor (180),
**characterized in that** the connector (100) is of one-piece design,
wherein the connector (100) facilitates the electrical connection between the circuit breaker (150) and the downstream contactor (180) and comprises at least one sensor (200),
wherein the connector (100) comprises an evaluation unit (210) for the measured values of the sensor (200), and
wherein the connector (100) comprises first contacts (101) for the circuit breaker (150) and second contacts (102) for the downstream contactor (180) in the same mating direction.

2. Connector (100) for a circuit breaker (150) and a downstream contactor (180) according to Claim 1, wherein the sensor (200) is in the form of a sensor for current measurement, for example in the form of a current transformer, and/or in the form of a sensor for voltage measurement.

3. Connector (100) for a circuit breaker (150) and a downstream contactor (180) according to Claim 1 or 2, wherein the sensor (200) is arranged electrically between the first contacts (101) and the second contacts (102) in or on the main circuit.

4. Connector (100) for a circuit breaker (150) and a downstream contactor (180) according to Claim 1, 2 or 3, wherein the connector (100) comprises an actuator (110) for actuating the downstream contactor (180).

5. Connector (100) for a circuit breaker (150) and a downstream contactor (180) according to any one of the preceding claims, wherein the connector (100) comprises a communication interface (119).

6. Connector (100) for a circuit breaker (150) and a downstream contactor (180) according to any one of the preceding claims, wherein the connector (100) comprises a read plunger (111) for the contactor position indicator.

7. Connector (100) for a circuit breaker (150) and a downstream contactor (180) according to any one of the preceding claims, wherein the connector (100) comprises an actuator (115) for actuating a reversing contactor.

8. Feeder (200) for connecting a load (1000), wherein the feeder (200) comprises a circuit breaker (150), a downstream contactor (180) and a connector (100) according to any one of the preceding claims, wherein the connector (100) forms the mechanical and/or electrical connection between the circuit breaker (150) and the downstream contactor (180).

9. Feeder (200) for connecting a load (1000) according to Claim 8, wherein the connector (100), the circuit breaker (150) and the downstream contactor (180) are connected to one another in a tool-based manner.

10. Feeder (200) for connecting a load (1000) according to Claim 8 or 9, wherein the feeder (200) can supply power to an electric motor as a load (1000).

11. Arrangement (2000) comprising a distribution system (2100), a load (1000) and a feeder (200) for switching a load (1000) according to any one of the preceding Claims 8 to 10, wherein the feeder (200) is arranged between the distribution system (2100) and the load (1000).

## Revendications

1. Connecteur (100) pour un disjoncteur (150) et un contacteur en aval (180),
**caractérisé en ce que**
le contacteur (100) est conçu d'un seul tenant,
le connecteur (100) permettant le raccordement électrique entre le disjoncteur (150) et le contacteur en aval (180) et comprenant au moins un capteur (200),
le connecteur (100) comprenant une unité d'évaluation (210) pour les valeurs de mesure du capteur (200), et
le connecteur (100) comprenant de premiers contacts (101) avec le disjoncteur (150) et de seconds contacts (102) avec le contacteur en aval (180) dans une même direction d'enfichage.

2. Connecteur (100) pour un disjoncteur (150) et un contacteur en aval (180) selon la revendication 1, dans lequel le capteur (200) est conçu comme un capteur de mesure d'intensité, par exemple comme un transformateur, et/ou comme un capteur de mesure de tension.

3. Connecteur (100) pour un disjoncteur (150) et un contacteur en aval (180) selon la revendication 1 ou 2, dans lequel le capteur (200) est disposé électriquement entre les premiers contacts (101) et les seconds contacts (102) dans ou sur le circuit principal.

4. Connecteur (100) pour un disjoncteur (150) et un contacteur en aval (180) selon la revendication 1, 2 ou 3, le connecteur (100) comprenant une commande (110) du contacteur en aval (180).

5. Connecteur (100) pour un disjoncteur (150) et un contacteur en aval (180) selon l'une des revendications précédentes, le connecteur (100) comprenant une interface de communication (119).

6. Connecteur (100) pour un disjoncteur (150) et un contacteur en aval (180) selon l'une des revendications précédentes, le connecteur (100) comprenant un bouton-poussoir de consultation (111) de l'affichage de position du contacteur.

7. Connecteur (100) pour un disjoncteur (150) et un contacteur en aval (180) selon l'une des revendications précédentes, le connecteur (100) comprenant une commande (115) pour un contacteur inverseur.

8. Embranchement (200) pour brancher un dispositif consommateur électrique (1000), l'embranchement (200) comprenant un disjoncteur (150), un contacteur en aval (180) et un connecteur (100) selon l'une des revendications précédentes, dans lequel le connecteur (100) constitue la liaison mécanique et/ou électrique entre le disjoncteur (150) et le contacteur en aval (180).

9. Embranchement (200) pour brancher un dispositif consommateur électrique (1000) selon la revendication 8, dans lequel le connecteur (100), le disjoncteur (150) et le contacteur en aval (180) sont liés ensemble en fonction des outils.

10. Embranchement (200) pour brancher un dispositif consommateur électrique (1000) selon la revendication 8 ou 9, dans lequel un moteur électrique peut être alimenté comme dispositif consommateur électrique (1000) à travers l'embranchement (200).

11. Arrangement (2000) à partir d'un réseau de distribution (2100), d'un dispositif consommateur électrique (1000) et d'un embranchement (200) pour commuter un dispositif consommateur électrique (1000) selon l'une des revendications précédentes 8 à 10, dans lequel l'embranchement (200) est disposé entre le réseau de distribution (2100) et le dispositif consommateur électrique (1000).
